# EUROPEAN PATENT SPECIFICATION

(11) **EP 1 749 116 B1**
(45) Date of publication and mention of the grant of the patent: **04.03.2015**
(21) Application number: 05749791.9
(22) Date of filing: 13.05.2005
(51) Int. Cl.: C23C 16/00, C23F 1/00, H01L 21/677, C23C 14/56, H01L 21/687, H01L 21/67

(54) **METHODS AND APPARATUSES FOR TRANSFERRING ARTICLES THROUGH A LOAD LOCK CHAMBER UNDER VACUUM**
VERFAHREN UND VORRICHTUNGEN ZUR FÜHRUNG VON GEGENSTÄNDEN DURCH EINE LADESCHLEUSENKAMMER UNTER VAKUUM
PROCEDES ET APPAREILS DE TRANSFERT D'ARTICLES PAR UN SAS DE CHARGEMENT SOUS VIDE

(30) Priority: 14.05.2004 US 571306 P
(43) Date of publication of application: 07.02.2007
(73) Proprietor: Ferrotec (USA) Corporation, Bedford, NH 03110 (US)
(72) Inventor: SAJJAD, Basha, S., Pleasanton, CA 94566 (US); SIN, Pheng, San Jose, CA 95121 (US); SENGUPTA, Subhashish, Vallejo, CA 94591 (US); EREZ, Shmuel, San Jose, CA 95117 (US); KRONEBERGER, Cris, Keith, Fairfield, CA 94533 (US)
(74) Representative: von Hellfeld, Axel
(86) International application number: PCT/US2005/017041
(87) International publication number: WO 2005/113853

(56) References cited:
- US-A- 3 568 632
- US-A- 3 641 973
- US-A- 3 656 454
- US-A- 3 656 454
- US-A- 4 047 624
- US-A- 4 699 555
- US-A- 5 881 649

## Description

### BACKGROUND OF THE INVENTION

The present invention relates generally to the field of manufacturing articles in low pressure environments. More specifically, the present invention relates to methods and apparatuses for transporting and handling small components, such as, integrated circuit wafers being processed in vacuum chambers, such as by evaporation, vapor deposition, sputtering, plasma etching, etc.

Integrated circuits, most commonly formed on either silicon (Si) semiconductor or compound semiconductor wafer substrates such as gallium arsenide (GaAs), and gallium nitride, are commonly subjected to one or more process steps within a vacuum chamber in the course of forming a large number of replicas of an integrated circuit on each wafer. In order to avoid having to inefficiently and continuously vent the vacuum processing chamber each time one or more wafers are loaded into or removed from the processing chamber, and then re-establish a vacuum before processing can continue, the wafers are often moved through an intermediate load lock chamber.

Wafers and other articles to be processed are loaded into the processing chamber by first moving them into the load lock chamber through its outside gate valve while the gate valve connecting the two chambers remains in the closed position. In this way, the processing chamber is maintained at or very close to its processing pressure during article loading and unloading. The outside gate valve is then closed with the articles to be processed in a load lock chamber, with the pressure in the load lock chamber then reduced. The gate between the processing chamber and the load lock chamber is then opened and the articles to be processed are moved into processing chamber from the load lock chamber. These steps are performed in a reverse order when removing processed articles from the processing chamber when the load lock chamber is at the reduced pressure similar to the processing chamber. Some known vacuum processing machines have two load lock chambers connected by separate gate valves to the processing chamber in order to increase the throughput of processed articles; one load lock chamber being used for loading and the other for unloading. Commonly assigned US Patent No. 6,609,877 and pending divisional application serial no. 10/621,700, filed July 17,2003 are both incorporated by reference herein in their entirety as if made a part of the present specification. This patent discloses useful methods and apparatuses for moving articles in a deposition chamber to increase article throughput via specific and restrictive article transfer within the deposition chamber. However, the pursuit of greater system efficiency and productivity, and product quality requires improved practicable and scalable solutions.

US 4,047,624 discloses a workpiece handling system comprising doors providing access to a loading and an unloading chamber, wherein each of the doors and a central chamber disposed between the loading and unloading chamber have rails while are aligned when the doors are closed such that a carrier provided with wheels can be guided along the rails from the loading chamber to the unloading chamber.

US 5,881,649 discloses a magnetic transfer system comprising a carrier for carrying an article to be processed, wherein the carrier is transported along fixed guide rails which extend through three chambers via a magnetic coupling system.

US 4,699,555 discloses a module positioning apparatus comprising a vacuum chamber with fixed guide rails and a motor-driven tape for transporting a cassette into the vacuum chamber.

US 3,656,454 discloses a vacuum coating apparatus comprising three chambers comprising two vacuum locks and a central coating chamber, wherein a substrate holder support carriage is disposed in each of the vacuum locks for transporting the carriage between the respective vacuum lock and the coating chamber. The substrate holders are moved into and out of the coating chamber by rotating around a crank arm rotated by an actuator.

The rate of "pump down" of a process chamber or a load lock chamber to process vacuum depends on the volume of the chamber, the total surface area, and is generally detrimental to system productivity, operating efficiencies and cost of ownership. Known processing chambers such as the above identified US Patent require rotational positioning of the carriers on which the articles are placed to receive processing. This rotational position comprises a "swap" of a plurality of carriers; swapping the carrier holding processed articles for a carrier holding articles to be processed. This rotational, simultaneous swap requires substantial area within the processing and staging areas in the chamber. An article transfer system that reduces operational, required volume for the chamber would be highly advantageous.

### SUMMARY OF THE INVENTION

A method for treating articles, a method for processing an article in a low pressure environment, and an apparatus for processing an article in a low pressure environment according to the appended independent claims are provided.

The present invention is directed to an article transfer system for processing chambers that significantly decreases the required chamber volume thus commensurately reducing the vacuum or "pump down" requirements of the processing system. Such reduced pump down times proportionately reduces system cycle times, which decreases system down time, and significantly increases system output and productivity.

The present invention is directed to an in-line linear article transfer apparatus, or linear transport system that does not require full rotation of large system components within a chamber. According to the present invention, processed articles are replaced with articles to be processed through an in-line article transfer apparatus resulting in beneficial effects on general and specific system size, productivity, operational efficiency and cost of ownership.

According to one aspect of the invention a method for vacuum treating articles is disclosed comprising providing a first chamber for processing an article with the first vacuum chamber comprising a linear transport array, and a carrier in moveable connection with the linear transport array. A second vacuum chamber is provided for staging an article to be directed into the first vacuum chamber, or directed from the first chamber to the second chamber via a linear transport array positioned to operate in concert with and between the first and second chambers. A first gate valve is provided and positioned between and in communication with the first and second chambers. The first gate valve has a closed position to seal the first chamber, and separate the first chamber from the second chamber, and an open position to allow a passageway between the first chamber and the second chamber. A dock station is provided for loading and unloading articles. Further, a second gate valve is positioned between and in communication with the second chamber and the dock station with the second gate valve having a closed position to seal and separate the second chamber from the dock station, and an open position to allow a passageway between the second chamber and the dock station. At least one vacuum pump is provided in communication with the first or second chamber, and a carrier is provided for supporting articles to be processed in the vacuum deposit chamber. The carrier is in communication with the linear transport array with the carrier having loaded thereon at least one article for processing. During the processing cycle, a low pressure is established and maintained by the vacuum, in the first and second chambers, while transporting at least one carrier between the first and second chambers. When moving in the direction from second chamber (staging chamber) to first chamber (processing chamber), unprocessed articles are being moved to the first chamber for processing. When moving in the direction from first chamber to second chamber, processed articles are moved from the processing chamber (first chamber) to the staging area (second chamber) for removal from the carrier. To increase system efficiency and shorten cycle times and increase product output, at least the first and second chambers are maintained at substantially similar pressures. In addition, a feature of the present invention is the operation of the gate valves, especially the first gate valve that is positioned during the system operation to maintain the first chamber (processing chamber) in a pumped-down, low pressure state. In this way, the article processing is efficient to an enhanced degree beyond all know systems as the low volume first chamber need not be subjected to substantially varied pressures when accepting articles to be processed and discharging newly processed articles, with the novel linear transport array responsible for directing transport of the articles.

According to a further aspect of the present invention, one preferred method further comprises positioning the first gate valve in the closed position and activating a vacuum pump to reduce pressure in the first chamber. The second gate valve is then opened followed by directing a carrier loaded with at least one article from the dock station into the second chamber. The second gate valve is then closed and the pressure is reduced in the second chamber to a pressure substantially similar to the pressure in the first chamber by "pumping down" the system. At this point in the cycle, the carrier holding articles to be processed is directed from the second chamber into the first chamber for article processing. Preferably, this carrier transfer occurs in concert with the transfer of articles on another carrier that have already been processed, from the first (processing) chamber to the second (staging) chamber. The transport of the carriers from first to second and second to first chambers takes place by engaging the linear transport system of the present invention to transport the carriers between substantially similarly pressurized chambers along rail guides.

According to yet another preferred aspect of the invention, the linear transport system comprises a magnetic coupled drive mechanism, and the articles to be processed are directed to the carrier, preferably in a closed environment, by an automated means, such as a robot. In this way, the automated means also directs the removal of processed articles from a carrier, preferably in a closed environment. In addition, in a further aspect of the invention, the placement and removal of articles to be processed, as well as the removal and storage of processed articles, respectively, is conducted in a dock station in communication with the first and second chambers, also may be under a pressure substantially similar to the pressure being maintained in the first and second chambers.

Still further, the application is directed to an apparatus for processing an article in a low pressure environment comprising a first chamber for processing an article. The first chamber comprises a linear transport array, and a carrier in moveable connection with the linear transport array. The apparatus further comprises a second chamber for staging an article to be directed into the first chamber for receiving a processed article from the first chamber. The second chamber also comprises a linear transport array that operates in concert with the array from the first chamber. A first gate valve is positioned between and in communication with the first and second chambers. The first gate valve has a closed position to seal the first chamber and an open position to allow a passageway between the first chamber and the second chamber. A dock station for loading and unloading articles is positioned adjacent a second gate valve such that the second gate valve is positioned between and in communication with the second chamber and the dock station. The second gate valve has a closed position to seal the second chamber and an open position to allow a passageway between the second chamber and the loading dock. At least one vacuum pump is in communication with the first or second chamber, and a carrier is in communication with the linear transport array. Low pressure is established and maintained in the first and second chambers while transporting at least one carrier between the first and second chambers, and processing the article held in the carrier in the first chamber. Preferably, the linear transport array comprises a drive mechanism including magnetic coupled drive mechanisms, hydraulic drive mechanisms, pneumatic drive mechanisms, electro-mechanical drive mechanisms, and mechanical drive mechanisms. In a further preferred embodiment, the carrier is loaded with articles to be processed by an automated means, most preferably, a robot. The automated means is also used to unload the processed articles from the carrier after article processing as well as load articles to be processed.

In yet another preferred embodiment of the present invention, the apparatus comprises first (processing) and second (staging) chambers that are able to be pumped down and maintained at substantially equivalent low pressures, such as are attainable by vacuum pumping. Alternately, the dock station also may be maintained in a low pressure environment.

### BRIEF DESCRIPTION OF THE DRAWINGS

Figure 1 is a perspective view of a processing chamber, load lock chamber and article loading front end with side panels removed to show the carrier transfer mechanism therein;
Figure 2 is a side view of the equipment of Figure 1;
Figures 3A - 3J schematically illustrate a sequence of operations of the equipment of Figures 1 and 2 to move articles between the processing chamber, load lock chamber and article loading front end;
Figure 4 is a perspective view of the integration of a magnetic coupled drive mechanism;
Figure 5 is a perspective cutaway view of a magnetic coupled drive mechanism;
Figure 6 is an enlarged view of an aspect of a magnetic coupled drive mechanism; and
Figure 7 is an enlarged perspective view of a magnetic coupled drive mechanism in operation.

Additional features, advantages and details of the present invention are included in the following description of exemplary embodiments of the invention, which description must be taken in conjunction with the accompanying drawings.

### DETAILED DESCRIPTION OF THE INVENTION

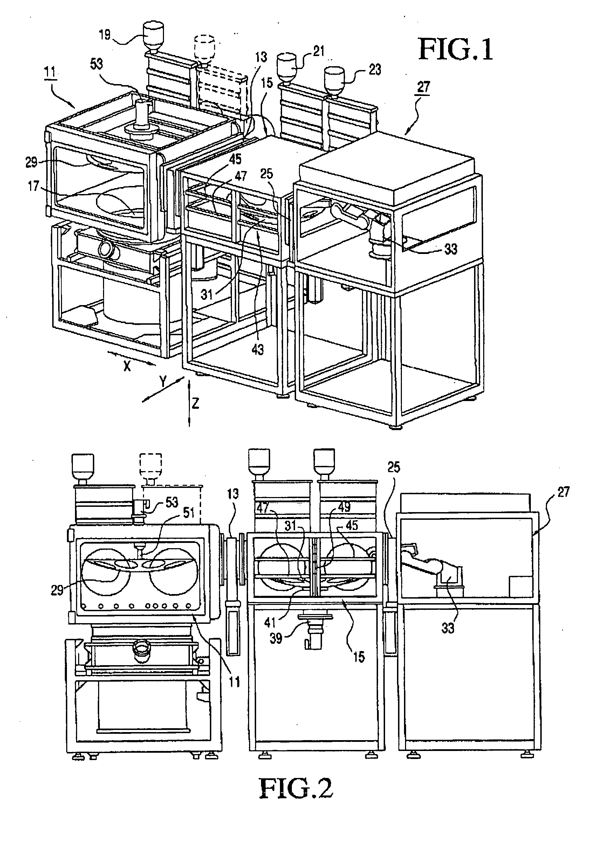

Figs. 1 and 2 show, in one embodiment of the invention, an apparatus of the invention that includes an article carrier transport mechanism whose structure and operation are described below. The articles in this case are semiconductor wafers that are moved into and out of a vacuum process chamber 11 on a carrier 29 through a gate valve 13 when opened to a load lock chamber 15. Alternatively, other types of substrates that are placed on a carrier may be handled in the same manner. The process carried out in the vacuum process chamber 11 may include depositing material on the wafers or other substrates from an evaporation source 17, for example. Alternatively, other processing of the substrates may take place in the vacuum process chamber 11. A vacuum pump 19 and associated valves reduces the pressure within the chamber 11, when the gate valve 13 is closed, to a desired level for carrying out the process. Wafers are loaded into and unloaded from the load lock chamber 15 through a gate valve 25 from a dock station 27. Vacuum pumps and associated valves 21 and 23 are operated to reduce the pressure within the load lock chamber 15 when gate valve 25 is closed.

Wafers not yet processed within the vacuum process chamber 11 are moved into that chamber from the load lock chamber 15 on one of two wafer carriers 29 and 31. Wafers are also removed from the vacuum process chamber 11 after processing therein on one of these carriers. The carriers 29 and 31 cycle back and forth between the two chambers 11 and 15. While no other carriers are necessary, the present invention contemplates the use of any number of carriers. The carriers need not be removed from the chambers 11 and 15, except for periodic cleaning. The carriers, as shown in Figs. 1 and 2, have the shape of an inverted dome (upwardly convex) with circular openings that are covered with the wafers being transported and processed. The present invention contemplates the use of carriers of any configuration as would be apparent to one skilled in the field of vapor deposition in light of the teachings herein. In a vapor deposition process within the vacuum process chamber 11, for example, vapor strikes the wafers through these openings. The shape of the carriers 29 and 31 maintain the wafers at a desired angle for the deposition. Therefore, the carriers can be made to have a different shape and/or structure, depending upon the requirements of the specific process being performed.

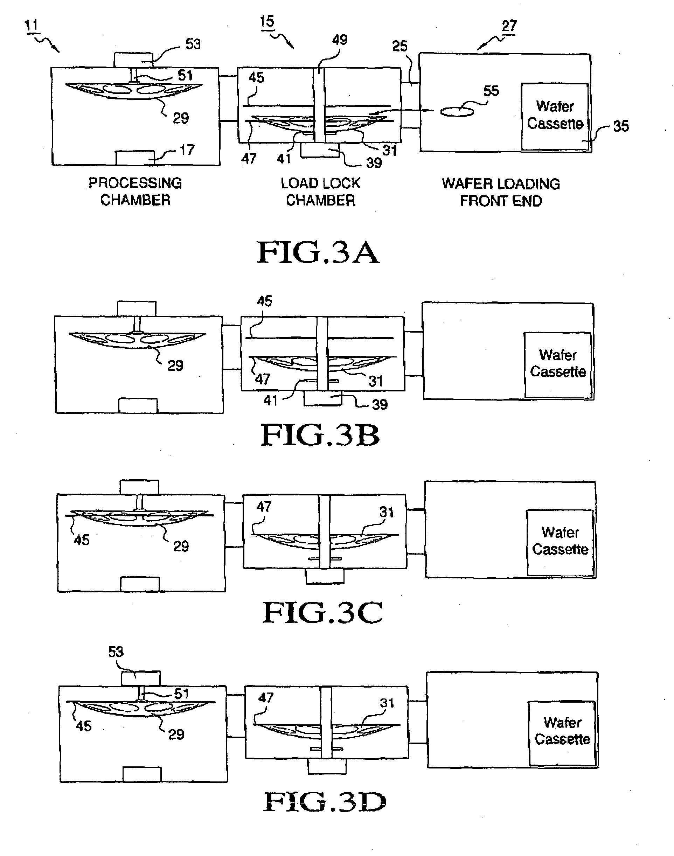

Wafers are removed from and loaded onto one of the carriers by a robot 33, such as a six-axis fully articulated clean room robot, installed in the loading dock 27. Alternatively, the robot may be a four-axis robot with a flip motion capability to turn over an individual wafer. In one embodiment, assuming a full carrier has just returned to the dock station, and therefore the carrier is holding a number of processed wafers, the arm of the robot removes a wafer from the carrier 31 and places it in a wafer cassette 35 (Figs. 3A - 3J) that is positioned in the dock. It then preferably picks up an unprocessed wafer from the cassette and positions it on the carrier in the same position from which a processed wafer was removed. Preferably, an index mechanism 39 then rotates a holder 41 on which the carrier 31 is resting and engaged during the wafer loading and unloading process. The carrier 31 is rotatably indexed to place another processed wafer it is carrying into position to be picked up by the robot 33. This other wafer is then also moved to the cassette and a fresh wafer moved from the cassette to the same position on carrier 31. This continues until all the processed wafers on the carrier 31 have been replaced with unprocessed wafers, after which the carrier 31 is moved from the load lock chamber 15 into the vacuum process chamber 11 and the carrier 29, containing the most recently processed wafers, is removed to the chamber 15 so that its wafers may then be exchanged with fresh unprocessed wafers by the robot 33. Alternatively, all processed wafers may be removed before any fresh wafers are placed on the carrier.

Once the cassette 35 is full of processed wafers, it is removed from the loading dock 27 and replaced with a cassette full of un-processed wafers, and the exchange continues with the wafers of the new cassette. Any of several standard types of cassettes may be employed. Optionally, a SMIF (Standard Mechanical InterFace) compatible cassette may be used. Additionally, a pre-aligner (not shown) is another option that may also be included in the loading dock 27, in order to align the rotation of processed wafers with respect to some feature on the wafers before placing them into the cassette. The loading dock 27 preferably includes a ULP A Filter FFU (Fan Filter Unit) for maintaining a clean environment. In a further embodiment, the dock station may also be maintained in a low pressure environment.

The carriers 29 and 31 are moved within and back-and-forth between the chambers 11 and 15 by a transport mechanism 43. In this embodiment, this mechanism includes two sets of rails: a rail 45 from one set and a rail 47 from another set being shown in the figures, the other rails of the two sets being hidden from view. The rails of each set are positioned on opposite sides of the wafer carriers in order to raise or lower a carrier in either or both of the chambers 11 or 15. The two sets of rails are raised or lowered (z-axis) along a vertical frame 49 by an appropriate motor source (not shown). In this example, they are maintained a fixed distance apart throughout their motion. This provides some safety in preventing one set of rails from inadvertently being pushed into wafers on a carrier held by the other set of rails, thus reducing the potential for damaging expensive wafers. Each set of rails is moveable laterally along the linear transport system (x-axis) between the chambers 11 and 15, independently of the other set. In the specific example being described, the two rails of the top set may additionally be movable a short distance toward and away from each other (y-axis), while such motion is unnecessary for the bottom set of rails. This complex motion imparts the necessary movement to engage, release and move the carriers 29 and 31 both within and between the chambers 11 and 15.

The carrier 29 (see Fig. 2) is suspended within the vacuum processing chamber 11 from a latch 51 during processing of the wafers it is carrying. The latch 51 may also be rotated by a mechanism 53 including a motor source, thereby rotating the carrier suspended from it. The mechanism 53 may also operate the latch 51 to release the carrier 29 when it is to be removed by the transport mechanism 43, and to grip the carrier when positioned against it by the transport 43 moving the carrier into the chamber 11.

Operation of the transport mechanism 43 of Figs. 1 and 2 to move the carriers 29 and 31 is illustrated by time sequential views of Figs. 3A - 3J. The point in the cycle illustrated in Fig. 3A is where wafers on the carrier 29 are being processed within the vacuum chamber 11. The gate valve 13 is closed. Simultaneously, individual wafers, such as a wafer 55, are being exchanged between the carrier 31 and the cassette 35 by the robot 33 (Figs. 1 and 2) in the manner described above. The gate door 25 is opened during the exchange.

After this wafer exchange is completed, the gate door 25 is closed and the pumps 21 and 23 are used to reduce the pressure within the load lock chamber 15 by opening their valves. The pumps typically run continuously while associated valves are operated to open and close their connection to the load lock chamber 15. While the pressure is being reduced, the rails 45 and 47 are raised to positions shown in Fig. 3B. The rail 47 initially engages the carrier 31 and lifts it off of the indexed holder 41. The rails 45 and 47 continue to be moved upwardly until the top rail 45 is at the correct elevation to be moved laterally into the processing chamber 11, the position shown in Fig. 3B. This position is a short distance below the position where the rail will engage and hold the carrier 29.

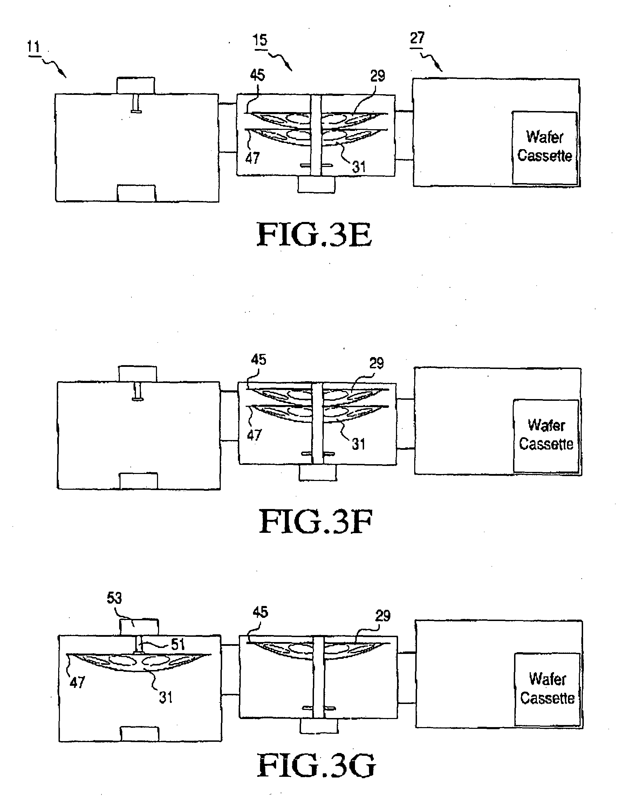

After the pressure within the chamber 15 has been reduced to a level close to that of the chamber 11, the gate valve 13 is opened and the top rail 45 moved into the position shown in Fig. 3C. The vertical position of the rail 45 is slightly below that which will engage the carrier 29. Once laterally positioned, the rails 45 and 47 are moved up a short distance, as shown in Fig. 3D, for the rail 45 to engage and hold the carrier 29. The carrier 29 is then released from the supporting latch 51 by the mechanism 53. The rail 45 is then moved down a short distance to clear the carrier 29 from the latch 51 and then moved laterally with the carrier back into the load lock chamber 15 to the position shown in Fig. 3E. Alternatively, the short vertical motion used to disengage the latch can be provided to the latch 51 by the mechanism 53. At this stage, both wafer carriers are in the chamber 15. The carrier 29 has the recently processed wafers removed from the processing chamber 11 and the carrier 31 is holding unprocessed wafers.

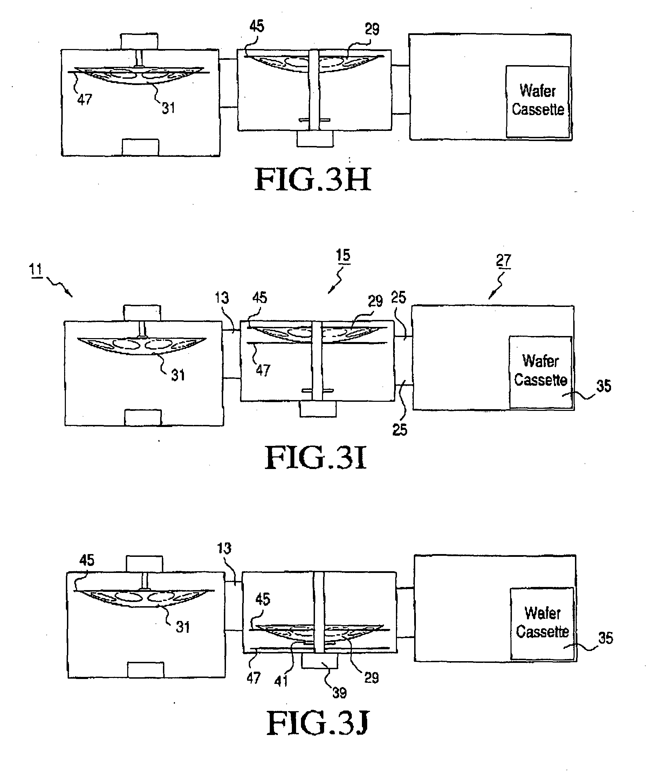

With the gate valve 13 opened and both chambers 11 and 15 at a low pressure, the carrier 31 with unprocessed wafers is moved into the processing chamber 11. A first step in this movement is shown in Figure 3F, where both rails are moved up within the load lock chamber 15 until the lower rail 47 is at a proper elevation to move the carrier 31 into the chamber 11. Next, as shown in Fig. 3G, the rail 47 is laterally moved into the vacuum process chamber 11 and then up a short distance to enable the latch 51 to be operated by the mechanism 53 to engage and support the carrier 31. Alternatively, the short vertical motion used to engage the latch 51 to the carrier 31 can be provided to the latch by the mechanism 53. The rails 45 and 47 are then lowered a short distance so that the rail 47 is separated from the carrier 31, as shown in Fig. 3H. The rail 47 is then moved laterally back into the load lock chamber 15, to its position shown in Fig. 3I.

The gate valve 13 is then closed, after which processing of the wafers on the carrier 31 can begin within the vacuum process chamber. The pressure within the load lock chamber 15 is then increased to the outside pressure and the gate valve 25 opened. While this is occurring, the rails are moved down from the position of Fig. 3I to that of Fig. 3J. In Fig. 3J, the carrier 29 is resting on the holder 41, no longer supported by the rail 45. The carrier 29 can then be rotated by the indexer 39 through the holder 41 on which the carrier 29 sits during the wafer exchange between the carrier 29 and the cassette 35 described above.

Before, during or after the wafer exchange, the rails 45 and 47 are raised from their lowest most positions shown in Fig. 3J to the position shown in Fig. 3A in preparation for the lower rail 47 to engage the other carrier 29 after the exchange is completed. The process of Figs. 3A - 3J is then repeated with the positions of the carriers 29 and 31 reversed. The rail 45 is made to be laterally moveable (along a y-axis) a short distance in order to clear the carrier 29 as the rail 45 is raised past the carrier 29 while it is sitting on the holder 41.

It may be noted that the rail 45 always moves the carrier holding processed wafers, (in this specific example), while the rail 47 moves the carrier holding un-processed wafers. This has the advantage of maintaining the processed wafers on the top carrier so that contaminants cannot fall onto them from the other carrier.

Figs. 3A-3J therefore represent one complete cycle of the wafer carrier movement that can be implemented by the equipment of Figs. 1 and 2. The wafer throughput is high, since the vacuum process chamber 11 is maintained at a low pressure (high vacuum) and the gate valve 13 need be opened for only a short time to exchange carriers. Since all the wafers to be exchanged are on only two carriers, the exchange can take place rapidly and therefore increase the percentage of time that wafers are being processed in the vacuum process chamber 11. Processing is minimally interrupted by this exchange of processed wafers (all on a first single carrier) and un-processed wafers (all on a second single carrier). Additionally, fresh wafers are loaded on one carrier in parallel with the wafers on the other carrier being processed.

The carrier transport mechanism 43 has an advantage of simplicity. In one contemplated design, each of the four rails (rail 45 and another in the top pair, and rail 47 and another in the bottom pair) may be made from two segments, one that telescopes out from the other along their lengths. The length of each segment is chosen to allow the rail to fit within the load lock chamber 15 when the segments are collapsed within each other. Vacuum compatible linear electric motors and guides may be mounted on the rails to provide this motion along the x-axis. For example, one such motor is mounted on the rail to move the telescoping segment with respect to the other segment, and another motor is mounted on the rail to move both segments with respect to the frame 49. This provides the range of motion in the x -axis that is described above with respect to Figs. 3A - 3J.

The rails of each set may be held apart vertically by posts, such as a post on the inside of the frame 49 and another (not shown) on a similar frame on an opposite side of the carriers. Vertical motion of the rails may then be provided by mounting a vacuum compatible linear electric motor and guides in each post. Movement of the top rails toward and away from each other along the y-axis may be provided by miniature pneumatic actuators mounted between the rails and the frame 49.

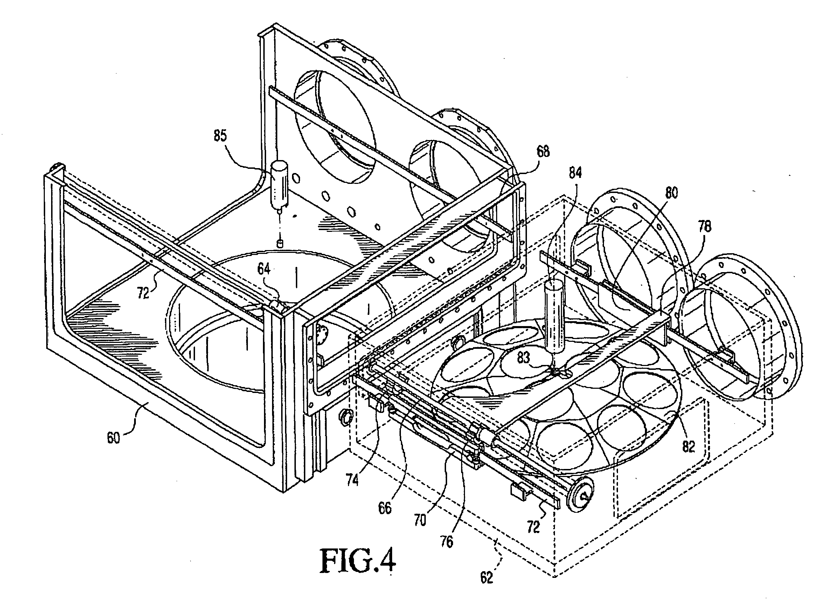

Fig. 4 shows a further preferred aspect of the present invention, whereby a magnetic coupled drive mechanism is installed to drive the linear transport array for placement of the samples to be processed and samples already processed, (e.g. wafers) held in the respective carriers between desired positions in the load lock chamber and the processing chamber. In this preferred embodiment, both process chamber 60 and load lock chamber 62 have independent magnetic coupled drive units, 64 and 66 respectively. The magnetic coupled drive units are preferably housed in a stainless tube (not shown) that is preferably vacuum sealed. Gate valve 68 provides the vacuum seal between chambers 60 and 62. The magnetic drive units are preferably maintained at atmospheric pressures. A carriage 70 guided on linear guides 72 is designed and oriented to "jump the gap" between process and load lock chambers without disengagement from the guide supports and without any discontinuous "jerks". The carriage 70 has two fixed magnets 74, 76 conforming to the curvature of the stainless steel tube housing the magnetic coupled drive. A cradle 78 is attached to the carriage 70 and is shown attached to a cradle support 80. The cradle 78 engages carrier 82 at the cradle engagement slot on dome flange 83 on the carrier 82. The spindle engagement slot on dome flange 83 engages the spindle 84 in the load lock chamber or spindle 85 in the process chamber.

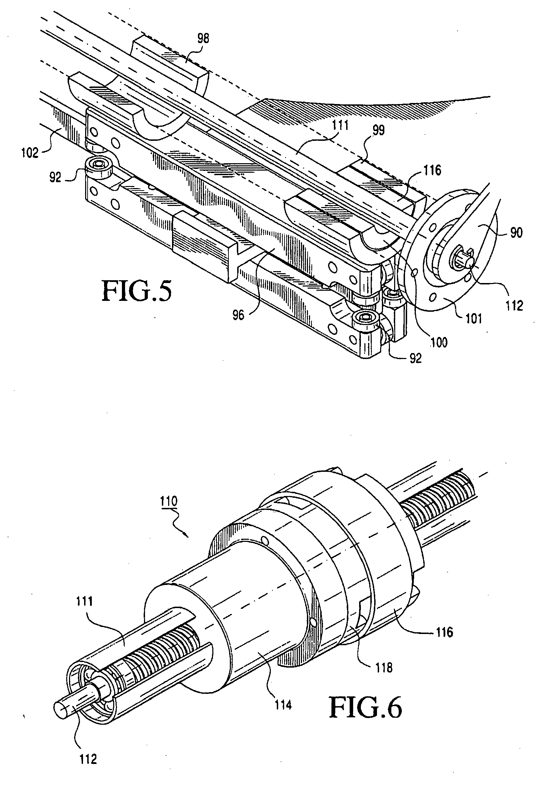

Fig. 5 is an exposed view of a magnetic coupled drive of the linear transport system of the present invention. A screw rail actuating lever 90 rotates screw rail 111 by 180 degrees clockwise or counterclockwise to engage or disengage the drive magnet 116 with either of the driven magnets 98 or 99 on the carriage 96, which travels along rail 102. Carriage 96 further comprises bearings 92. The distance between magnets 98 and 99 facilitates a "jerk free handshake" between the process chamber magnetic coupled drive and load lock magnetic drive. Magnetic coupled drive 100 is preferably housed in a stainless tube isolated from vacuum through a vacuum flange 101 with o-ring seals. Driver magnet 116 is shown to engage with front driven magnet 99 on the carriage 96. When the lead screw 112 is rotated, such as with an electric motor (not shown), the screw rail nut 114 along with the driver magnet 116 advances or retracts linearly as it is guided by the screw rail 111. The driver magnet is coupled with the driven magnet 99, attached to the carriage 96, imparting linear motion to the carriage 96.

Fig. 6 is an exposed view of aspects of the magnetic coupled drive 110. A drive mechanism comprises a screw rail 111 with lead screw 112 with a zero backlash split nut 114, and a driver magnet 116 conforming to the curvature of the magnet holder 118 attached to the magnetic holder.

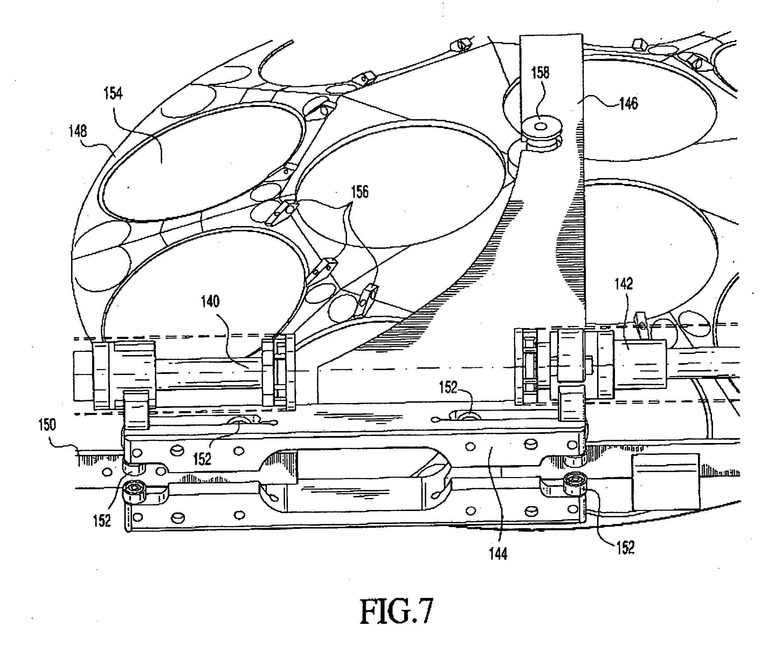

Fig. 7 is an exposed perspective view of one embodiment of the present invention. This view illustrates the concept of "hand shake" between the magnetic coupled drive unit 140 in the load lock chamber and the magnetic coupled drive unit 142 in the processing chamber when the carriage 144 (that supports the cradle 146 with the dome 148) is moving between the chambers on the guide rail 150 through the gate valve (not shown). In operation, the drive magnet in the load lock magnetic coupled drive unit is disengaged with the magnet on the carriage by actuating the screw rail actuating lever on the load lock magnetic drive. The drive magnet in the process chamber magnetic couple drive unit is engaged with the magnet on the far side of the carriage by actuating the screw rail actuating lever on the process chamber magnetic coupled drive. The carriage is well supported both in the longitudinal and vertical direction by a set of roller bearings on the guide rail 152.

As shown in Fig. 7, the article carrier, or "dome" 148 is designed to hold wafers or other articles to be processed. In one embodiment of the present invention, the articles are fragile wafers. Therefore, it is preferred to move the wafer carrier or "dome" with the wafers attached thereto, rather than attempt to directly contact the wafers during station to station transport during processing. The number of wafers or articles processed, and held in place on the carrier is dependent upon the number of receiving areas on the carrier. In turn, the number of receiving areas or site (which appear as cutouts or "holes") are dependent upon the dimensions of the wafers or other articles. Thus, a 150 mm or 200 mm diameter circular wafer will obviously take up more space on a carrier than will a 50 mm wafer. The circular receptacles 154 are designed to receive articles of similar dimension for processing. Since the dome carriers can be quite large and awkward to move about the chamber for article placement and removal, according to a further aspect of the present invention, the dome surface may be divided into wedge-shaped segments that are removably held on a circular frame such that when all segments are in place, a completed dome-shaped carrier is effected. Therefore, the dome 148 is further designed to be constructed from separate removable segments held together by fasteners such as spring clips 156 such that when the segments are in position, the complete dome is intact. The fully assembled dome is moved between the process chamber and the load lock chamber.

The segments may be moved individually from the load lock chamber to the "front end" for article loading and unloading. Such an arrangement reduces the weight and size of the carrier component being handled for article placement and removal for smaller size articles, such as wafers having a 150 mm diameter. Larger wafers, such as 200 mm diameter wafers are preferably loaded and unloaded individually from the load lock chamber through the dock station, preferably with an automated means, such as, a robot that is preferably located in the dock station. In addition, to further minimize the area necessary to swap locations of two such dome segments, the pointed ends of the segments may be truncated without significant loss of wafer or article carrying capacity on the dome. The dome, as shown, has a dual slot flange 158. The bottom slot engages the cradle 146, and the top slot engages a spindle in the process chamber (84 in Fig. 4) and load lock chamber (85 in Fig. 4). It is to be further understood that the dome may be positioned in an inverted state such that the dome holds articles to be processed in either a concave or convex or even planar orientation. If a process other than evaporation deposition is being performed within the processing chamber, a different type and shape of carrier may be used. A flat plate, where wafers are carried on a planar surface, or a "boat", where wafers are held in a non-planar orientation are further possibilities contemplated by the present invention. Further, each wafer or article can alternatively be transferred and processed individually. However, this is comparatively inefficient and usually not suitable for most wafer processing, such as gallium arsenide wafer processing. As discussed above, for larger diameter articles, such as 200 mm diameter wafers, the dome comprises individual segments provided with accurately machined sockets and tabs for precisely locating and engaging the segments. Such segments are preferably held together with fasteners, such as spring clips. Preferably, there are machined features on the segments to index the dome accurately, thus facilitating automated article loading and unloading. The dome is preferably made from a stainless steel, however, the dome may be constructed from any useful material capable of withstanding the rigors of sustained processing environments, as would be readily understood by one skilled in the field of vacuum deposition chambers in light of the disclosures made herein.

The present invention contemplates the use of any magnetic coupled drive units that would perform the desired effects. Such desirable units are made by Transfer Engineering (Fremont, CA), but other workable units could be used as would be readily apparent to one skilled in the field of magnetic drive units in light of the disclosures made herein.

As stated above, the low pressure maintained in the processing chamber is basically preserved due to the pressurization of the load lock chamber before opening the gate valve that seals the processing chamber from the load lock chamber. In this way, the processing chamber is never purged, and this obviates the need to continually purge and again pump down the processing chamber. Typical processing pressures maintained in the process chamber are from about 10⁻⁶ to about 10⁻⁷ torr. In one embodiment of the present invention, the load lock chamber is exposed to ambient conditions during carrier/article loading. When the second gate valve is in the closed position, the load lock chamber is then pumped down from atmospheric pressure to about 10⁻⁵ torr in less than about 3 minutes. At this point the first gate valve is opened and the combined load lock chamber and processing chamber is pumped down to the desired operating pressure of from about 10⁻⁶ to about 10⁻⁷ torr. The total pumping down time is less than about 5 minutes, based on the design of the vacuum pump and the desired, low volume design of the chambers and in particular the load lock chamber. This is in significant contrast to known processing systems where pumping down times exceed from about 17 to about 20 minutes, creating significantly more down time than the processes of the present invention. The preferred volume of the load lock chamber designed for use in the processes of the present invention is about 20 cfm, and more preferably has a volume in the range of from about 10 to about 15 cfm. This restricted load lock chamber volume allows for shortened pumping down cycles, resulting in greater efficiency and product throughput.

In addition, according to the present invention, system efficiency is created and preserved by keeping carrier swap time to a minimum by maintaining a carrier with articles to be processed in a ready position during article processing cycles when another carrier occupies the processing chamber. Further, the system can be altered to accept a plurality of carriers in either or both of the load lock and processing chambers to meet product throughput demands.

For the purposes of this application, it is to be understood that the terms "linear or in-line transport array" and "linear or in-line transport system" are equivalent and interchangeable terms. Further, as explained herein, the linear transport systems of the present invention may comprise any drive system capable of driving the carriers in a linear direction from one point to another. Still further, it is to be understood that the linear transport systems of the present invention desirably comprise a support system, typically rail guides, in both the processing chamber and the staging chamber. However, the present invention further contemplates embodiments whereby the supports, or rail guides are not fixed, but comprise a component of the drive system. In this way, the rail guides could be initially located only in one chamber, but, upon operation, could extend and retract into more than one chamber as required by the system. Such a system, could be used in conjunction with a "telescoping" system where by the drive unit is called upon to supply motion to the carrier and the rail guides that are moved into the desired position in advance of, or commensurate with the movement of the carrier.

Although the various aspects of the present invention have been described with respect to specific examples and embodiments thereof, it will be understood that the invention is entitled to protection within the full scope of the appended claims.

## Claims

1. A method for treating articles comprising:
providing a first chamber (11) configured for processing at least one article;
providing a second chamber (15) for staging the at least one article;
providing a linear transport system (43);
providing a first gate valve (13) positioned between and in communication with the first and second chambers (11, 15), said first gate valve (13) having a closed position to seal the first chamber (11) and an open position to allow a passageway between the first chamber (11) and the second chamber (15);
providing a dock station (27) configured for loading and unloading the at least one article;
providing a second gate valve (25) positioned between and in communication with the second chamber (15) and the dock station (27), said second gate valve (25) having a closed position to seal the second chamber (15) and an open position to allow a passageway between the second chamber (15) and the dock station (27);
providing at least one vacuum pump (19) in communication with the first or second chamber (11, 15);
providing a plurality of carriers (29, 31) configured to support the at least one article to be treated;
loading the at least one article onto one of the plurality of carriers (29, 31);
establishing and maintaining a low pressure in the first and second chambers (11, 15) while transporting at least one of the plurality of carriers (29, 31) via the linear transport system (43) between the first and second chambers (11, 15) such that one carrier (29, 31) comprising the at least one article to be treated is disposed in the first chamber (11); and
processing the at least one article supported by the carrier (29, 31) in the first chamber (11);
**characterized in that** the linear transport system (43) comprises a plurality of sets of rails (45, 47), a number of the sets of rails (45, 47) corresponding to a number of the carriers (29, 31), configured to move laterally independently of each other along the linear transport system (43) between the first chamber (11) and the second chamber (15), wherein each of the plurality of sets of rails (45, 47) is configured to support one of the plurality of carriers (29, 31).

2. The method of Claim 1, wherein the dock station (27) comprises an article loader and unloader (33).

3. The method of Claim 1, wherein the linear transport system (43) comprises a drive system selected from the group consisting of: hydraulic systems, electro-mechanical systems, and magnetic coupled drive systems.

4. The method of Claim 1, wherein the linear transport system (43) comprises a magnetic coupled drive system.

5. The method of Claim 1, further comprising the steps of:
positioning the first gate valve (13) in the closed position and activating the vacuum pump (19) to reduce pressure in the first chamber (11);
opening the second gate valve (25) and directing one of the plurality of carriers (29, 31) loaded with at least one article from the dock station (27) into the second chamber (15);
closing the second gate valve (25) and reducing pressure in the second chamber (15) to a pressure substantially similar to the pressure in the first chamber (11); and
opening the first gate valve (13) and directing the carrier (29, 31) from the second chamber (15) into the first chamber (11) via the linear transport system (43) and processing the at least one article.

6. The method of Claim 5, wherein a predetermined pressure differential exists between the first and second chambers (11, 15) before the first gate valve (13) is opened.

7. The method of Claim 6, wherein the predetermined pressure differential is less than about 10-1 torr.

8. The method of Claim 5, further comprising the steps of: engaging the linear transport system (32) to transport the carrier between substantially similarly pressurized chambers along the sets of rails (45, 47).

9. The method of Claim 1, wherein the loading of the at least one article onto the carriers (29, 31) is accomplished by a robot (33).

10. The method of Claim 9, further comprising the steps of:
providing a plurality of articles from an article source to be loaded onto one of the plurality of carriers (29, 31); and
engaging the robot (33) to load the articles onto one of the plurality of carriers (29, 31).

11. The method of Claim 1, further comprising the steps of:
after processing the article, directing the second gate valve (25) to the closed position and the first gate valve (13) to the open position;
directing one of the plurality of carriers (29, 31) from the first chamber (11) to the second chamber (15);
directing the first gate valve (13) to the closed position; and
opening the second gate valve (25) and directing a robot (33) to remove the processed article from one of the at least one carriers (29, 31).

12. The method of Claim 11, wherein the linear transport system (43) comprises a magnetic coupled drive mechanism.

13. The method of Claim 1, further comprising the steps of:
providing at least one article to be processed, said article provided at a dock station (27);
transferring the article to the second chamber (15) from the dock station (27) through a second gate valve (25);
substantially equilibrating the first and second chambers (11, 15) to a substantially similar pressure;
transporting the article from the second chamber (15) through the first gate valve (13) to the first chamber (11) along the linear transport system (43); and
transporting the article from the first chamber (11) through the first gate valve (13) to the second chamber (15) along the linear transport system (43).

14. The method of Claim 13, further comprising the step of: directing the first and second gate valves (13, 25) to open or closed positions to facilitate transporting the article into and away from the first chamber (11) while subjecting the article to a substantially constant pressure.

15. The method of Claim 13, further comprising the steps of:
directing the first gate valve (13) to a closed position during article treatment in the first chamber (11) while simultaneously introducing at least one article to be processed to the second chamber (15);
after introducing at least one article to the second chamber (15), directing the second gate valve (25) to a closed position, and directing the first gate valve (13) to an open position;
transporting at least one article from the first chamber (11) through the first gate valve (13) to the second chamber (15) along the linear transport system (43); and
transporting at least one article from the second chamber (15) through the first gate valve (13) to the first chamber (11) along the linear transport system (43).

16. The method of Claim 13, wherein the linear transport system (43) comprises a magnetic coupled drive mechanism.

17. The method of Claim 13, further comprising the step of: maintaining the dock station (27) at a pressure substantially similar to the first and second chambers (11, 15).

18. An apparatus for processing an article in a low pressure environment comprising:
a first chamber (11) configured for processing an article;
a plurality of carriers (29, 31) configured to support at least one article to be processed;
a second chamber (15) configured for staging the at least one article to be directed into the first chamber (11) or directed from the first chamber (11);
a linear transport system (43);
a first gate valve (13) positioned between and in communication with the first and second chambers (11, 15), said first gate valve (13) having a closed position to seal the first chamber (11) and an open position to allow a passageway between the first chamber (11) and the second chamber (15);
a dock station (27) configured for loading and unloading the at least one article;
a second gate valve (25) positioned between and in communication with the second chamber (15) and the dock station (27), said second gate valve (25) having a closed position to seal the second chamber (15) and an open position to allow a passageway between the second chamber (15) and the loading dock (27); and
at least one vacuum pump (19) in communication with the first or second chamber (11, 15);
**characterized in that** the linear transport system (43) comprises a plurality of sets of rails (45, 47), a number of the sets of rails (45, 47) corresponding to a number of the carriers (29, 31), configured to move laterally independently of each other along the linear transport system (43) between the first chamber (11) and the second chamber (15), wherein each of the plurality of sets of rails (45, 47) is configured to support one of the plurality of carriers (29, 31).

19. The apparatus of Claim 18, wherein a low pressure is established and maintained in the first and second chambers (11, 15) while transporting at least one of the plurality of carriers (29, 31) between the first and second chambers (11, 15), and while processing the article held in the carrier in the first chamber (11).

20. The apparatus of Claim 18, wherein each of the plurality of carriers (29, 31) is configured to support a plurality of articles.

21. The apparatus of Claim 20, wherein the articles comprise a plurality of wafers.

22. The apparatus of Claim 18, wherein the plurality of carriers (29, 31) are dome shaped.

23. The apparatus of Claim 18, wherein the linear transport system (43) comprises a drive mechanism selected from the group consisting of: magnetic coupled drive mechanism, hydraulic drive mechanism, pneumatic drive mechanism, electro-mechanical drive mechanism, and mechanical drive mechanism.

24. The apparatus of Claim 18, wherein the linear transport system (43) comprises at least one magnetic coupled drive mechanism.

25. The apparatus of Claim 18, further comprising an automated means (33) for directing wafers to the plurality of carriers (29, 31) before processing the wafers.

26. The apparatus of Claim 18 further comprising an automated means (33) for removing processed wafers from the plurality of carriers (29, 31).

27. The apparatus of Claim 25, wherein the automated means comprises a robot (33).

28. The apparatus of Claim 26, wherein the automated means comprises a robot (33).

29. The apparatus of Claim 18, wherein the first and second chambers (11, 15) are maintained at substantially equivalent pressures.

30. The apparatus of Claim 18, wherein the docking station (27) is maintained at a pressure substantially similar to the first and second chambers (11, 15).

## Patentansprüche

1. Verfahren zum Behandeln von Artikeln, das umfasst:
- Bereitstellen einer ersten Kammer (11), die zum Bearbeiten wenigstens eines Artikels ausgelegt ist,
- Bereitstellen einer zweiten Kammer (15) zum Bereitstellen des wenigstens einen Artikels,
- Bereitstellen eines linearen Transportsystems (43),
- Bereitstellen eines ersten Durchgangsventils (13), das zwischen und in Verbindung mit der ersten und zweiten Kammer (11, 15) angeordnet ist, wobei das erste Durchgangsventil (13) eine geschlossene Stellung zum Abdichten der ersten Kammer (11) und eine offene Stellung zum Ermöglichen eines Durchgangs zwischen der ersten Kammer (11) und der zweiten Kammer (15) hat,
- Bereitstellen einer Dockstation (27), die zum Laden und Entladen des wenigstens einen Artikels ausgelegt ist,
- Bereitstellen eines zweiten Durchgangsventils (25), das zwischen und in Verbindung mit der zweiten Kammer (15) und der Dockstation (27) angeordnet ist, wobei das zweite Durchgangsventil (25) eine geschlossene Stellung zum Abdichten der zweiten Kammer (15) und eine offene Stellung zum Ermöglichen eines Durchgangs zwischen der zweiten Kammer (15) und der Dockstation (27) hat,
- Bereitstellen wenigstens einer Unterdruckpumpe (19), die mit der ersten oder zweiten Kammer (11, 15) in Verbindung steht,
- Bereitstellen einer Mehrzahl Träger (29, 31), die zum Halten des wenigstens einen zu behandelnden Artikels ausgelegt sind,
- Laden des wenigstens einen Artikels auf einen der Mehrzahl Träger (29, 31),
- Aufbauen und Aufrechterhalten eines niedrigen Drucks in der ersten und zweiten Kammer (11, 15) während des Transports wenigstens eines der Mehrzahl Träger (29, 31) über das lineare Transportsystem (43) zwischen der ersten und zweiten Kammer (11, 15), so dass ein Träger (29, 31), der den wenigstens einen zu behandelnden Artikel enthält, in der ersten Kammer (11) angeordnet ist, und
- Bearbeiten des wenigstens einen Artikels, der vom Träger (29, 31) in der ersten Kammer (11) gehalten wird,
- **dadurch gekennzeichnet, dass** das lineare Transportsystem (43) eine Mehrzahl Schienensätze (45, 47) umfasst, wobei die Anzahl der Schienensätze (45, 47) der Anzahl der Träger (29, 31) entspricht, welche dafür ausgelegt sind, sich unabhängig voneinander längs des linearen Transportsystems (43) seitlich zwischen der ersten Kammer (11) und der zweiten Kammer (15) zu bewegen, wobei jeder der Mehrzahl Schienensätze (45, 47) dafür ausgelegt ist, einen der Mehrzahl Träger (29, 31) zu halten.

2. Verfahren nach Anspruch 1, wobei die Dockstation (27) eine Artikel-Lade-/Entladeeinrichtung (33) umfasst.

3. Verfahren nach Anspruch 1, wobei das lineare Transportsystem (43) ein Antriebssystem umfasst, das aus der Gruppe ausgewählt wird, die aus hydraulischen Systemen, elektromechanischen Systemen und magnetisch gekoppelten Antriebssystemen besteht.

4. Verfahren nach Anspruch 1, wobei das lineare Transportsystem (43) ein magnetisch gekoppeltes Antriebssystem umfasst.

5. Verfahren nach Anspruch 1, das ferner die Schritte umfasst:
- Positionieren des ersten Durchgangsventils (13) in der geschlossenen Stellung und Aktivieren der Unterdruckpumpe (19), um den Druck in der ersten Kammer (11) zu verringern,
- Öffnen des zweiten Durchgangsventils (25) und Führen eines der Mehrzahl Träger (29, 31), der mit wenigstens einem Artikel von der Dockstation (27) beladen ist, in die zweite Kammer (15),
- Schließen des zweiten Durchgangsventils (25) und Verringern des Drucks in der zweiten Kammer (15) auf einen Druck, der im Wesentlichen dem Druck in der ersten Kammer (11) gleicht, und
- Öffnen des ersten Durchgangsventils (13) und Führen des Trägers (29, 31) über das lineare Transportsystem (43) von der zweiten Kammer (15) in die erste Kammer (11) und Bearbeiten des wenigstens einen Artikels.

6. Verfahren nach Anspruch 5, wobei vor dem Öffnen des ersten Durchgangsventils (13) zwischen der ersten und zweiten Kammer (11, 15) eine vorgegebene Druckdifferenz herrscht.

7. Verfahren nach Anspruch 6, wobei die vorgegebene Druckdifferenz weniger als ungefähr 10-1 Torr beträgt.

8. Verfahren nach Anspruch 5, das ferner die Schritte umfasst: Ineingriffbringen des linearen Transportsystem (32) zum Transportieren des Trägers zwischen im Wesentlichen gleichermaßen unter Druck stehenden Kammern längs der Schienensätze (45, 47).

9. Verfahren nach Anspruch 1, wobei das Laden des wenigstens einen Artikels auf die Träger (29, 31) durch einen Roboter (33) ausgeführt wird.

10. Verfahren nach Anspruch 9, das ferner die Schritte umfasst:
- Bereitstellen einer Mehrzahl Artikel aus einer Artikelquelle, die auf einen der Mehrzahl Träger (29, 31) zu laden sind, und
- Ineingriffbringen des Roboters (33) zum Laden der Artikel auf einen der Mehrzahl Träger (29, 31).

11. Verfahren nach Anspruch 1, das ferner die Schritte umfasst:
- nach dem Bearbeiten des Artikels, Führen des zweiten Durchgangsventils (25) in die geschlossene Stellung und des ersten Durchgangsventils (13) in die offene Stellung,
- Führen eines der Mehrzahl Träger (29, 31) von der ersten Kammer (11) in die zweite Kammer (15),
- Führen des ersten Durchgangsventils (13) in die geschlossene Stellung, und
- Öffnen des zweiten Durchgangsventils (25) und Führen eines Roboters (33), um den bearbeiteten Artikel aus einem der wenigstens einen Träger umfassenden Träger (29, 31) zu entfernen.

12. Verfahren nach Anspruch 11, wobei das lineare Transportsystem (43) einen magnetisch gekoppelten Antriebsmechanismus umfasst.

13. Verfahren nach Anspruch 1, das ferner die Schritte umfasst:
- Bereitstellen wenigstens eines zu bearbeitenden Artikels, wobei der Artikel an einer Dockstation (27) bereitgestellt wird,
- Überführen des Artikels von der Dockstation (27) durch ein zweites Durchgangsventil (25) in die zweite Kammer (15),
- im Wesentlichen Abgleichen der ersten und zweiten Kammer (11, 15) auf einen im Wesentlichen gleichen Druck,
- Transportieren des Artikels längs des linearen Transportsystems (43) von der zweiten Kammer (15) durch das erste Durchgangsventil (13) in die erste Kammer (11), und
- Transportieren des Artikels längs des linearen Transportsystems (43) von der ersten Kammer (11) durch das erste Durchgangsventil (13) in die zweite Kammer (15).

14. Verfahren nach Anspruch 13, das ferner den Schritt umfasst: Führen des ersten und zweiten Durchgangsventils (13, 25) in die offene oder geschlossene Stellung, um den Transport des Artikels in und aus der ersten Kammer (11) zu ermöglichen während der Artikel einem im Wesentlichen konstanten Druck ausgesetzt ist.

15. Verfahren nach Anspruch 13, das ferner die Schritte umfasst:
- Führen des ersten Durchgangsventils (13) während der Artikelbehandlung in der ersten Kammer (11) in eine geschlossene Stellung und gleichzeitiges Einbringen wenigstens eines zu bearbeitenden Artikels in die zweite Kammer (15),
- nach dem Einbringen wenigstens eines Artikels in die zweite Kammer (15), Führen des zweiten Durchgangsventils (25) in eine geschlossene Stellung und Führen des ersten Durchgangsventils (13) in eine offene Stellung,
- Transportieren wenigstens eines Artikels längs des linearen Transportsystems (43) von der ersten Kammer (11) durch das erste Durchgangsventil (13) in die zweite Kammer (15), und
- Transportieren wenigstens eines Artikels längs des linearen Transportsystems (43) von der zweiten Kammer (15) durch das erste Durchgangsventil (13) in die erste Kammer (11).

16. Verfahren nach Anspruch 13, wobei das lineare Transportsystem (43) einen magnetisch gekoppelten Antriebsmechanismus umfasst.

17. Verfahren nach Anspruch 13, das ferner den Schritt umfasst: Halten der Dockstation (27) auf einem Druck, der im Wesentlichen dem der ersten und zweiten Kammer (11, 15) gleicht.

18. Vorrichtung zum Bearbeiten eines Artikels in einer Niederdruckumgebung, die umfasst:
- eine erste Kammer (11), die zum Bearbeiten eines Artikels ausgelegt ist,
- eine Mehrzahl Träger (29, 31), die zum Halten wenigstens eines zu bearbeitenden Artikels ausgelegt sind,
- eine zweite Kammer (15), die zum Bereitstellen des wenigstens einen Artikels ausgelegt ist, der in die erste Kammer (11) oder aus der ersten Kammer (11) zu führen ist,
- ein lineares Transportsystem (43),
- ein erstes Durchgangsventil (13), das zwischen und in Verbindung mit der ersten und zweiten Kammer (11, 15) angeordnet ist, wobei das erste Durchgangsventil (13) eine geschlossene Stellung zum Abdichten der ersten Kammer (11) und eine offene Stellung zum Ermöglichen eines Durchgangs zwischen der ersten Kammer (11) und der zweiten Kammer (15) hat,
- eine Dockstation (27), die zum Laden und Entladen des wenigstens einen Artikels ausgelegt ist,
- ein zweites Durchgangsventil (25), das zwischen und in Verbindung mit der zweiten Kammer (15) und der Dockstation (27) angeordnet ist, wobei das zweite Durchgangsventil (25) eine geschlossene Stellung zum Abdichten der zweiten Kammer (15) und eine offene Stellung zum Ermöglichen eines Durchgangs zwischen der zweiten Kammer (15) und der Dockstation (27) hat, und
- wenigstens eine Unterdruckpumpe (19), die mit der ersten oder zweiten Kammer (11, 15) in Verbindung steht,
- **dadurch gekennzeichnet, dass** das lineare Transportsystem (43) eine Mehrzahl Schienensätze (45, 47) umfasst, wobei die Anzahl der Schienensätze (45, 47) der Anzahl der Träger (29, 31) entspricht, welche dafür ausgelegt sind, sich unabhängig voneinander längs des linearen Transportsystems (43) seitlich zwischen der ersten Kammer (11) und der zweiten Kammer (15) zu bewegen, wobei jeder der Mehrzahl Schienensätze (45, 47) dafür ausgelegt ist, einen der Mehrzahl Träger (29, 31) zu halten.

19. Vorrichtung nach Anspruch 18, wobei, während des Transports wenigstens eines der Mehrzahl Träger (29, 31) zwischen der ersten und zweiten Kammer (11, 15) und während der Bearbeitung des im Träger in der ersten Kammer (11) gehaltenen Artikels, in der ersten und zweiten Kammer (11, 15) ein niedriger Druck aufgebaut und aufrechterhalten wird.

20. Vorrichtung nach Anspruch 18, wobei jeder der Mehrzahl Träger (29, 31) dafür ausgelegt ist, eine Mehrzahl Artikel zu halten.

21. Vorrichtung nach Anspruch 20, wobei die Artikel eine Mehrzahl Wafer umfassen.

22. Vorrichtung nach Anspruch 18, wobei die Mehrzahl Träger (29, 31) kuppelförmig sind.

23. Vorrichtung nach Anspruch 18, wobei das lineare Transportsystem (43) einen Antriebsmechanismus umfasst, der aus der Gruppe ausgewählt wird, die aus einem magnetisch gekoppelten Antriebsmechanismus, einem hydraulischen Antriebsmechanismus, einem pneumatischen Antriebsmechanismus, einem elektromechanischen Antriebsmechanismus und einem mechanischen Antriebsmechanismus besteht.

24. Vorrichtung nach Anspruch 18, wobei das lineare Transportsystem (43) wenigstens einen magnetisch gekoppelten Antriebsmechanismus umfasst.

25. Vorrichtung nach Anspruch 18, die ferner eine automatisierte Einrichtung (33) zum Führen von Wafern zu der Mehrzahl Träger (29, 31) umfasst, und zwar vor dem Bearbeiten der Wafer.

26. Vorrichtung nach Anspruch 18, die ferner eine automatisierte Einrichtung (33) zum Entfernen bearbeiteter Wafer aus der Mehrzahl Träger (29, 31) umfasst.

27. Vorrichtung nach Anspruch 25, wobei die automatisierte Einrichtung einen Roboter (33) umfasst.

28. Vorrichtung nach Anspruch 26, wobei die automatisierte Einrichtung einen Roboter (33) umfasst.

29. Vorrichtung nach Anspruch 18, wobei die erste und zweite Kammer (11, 15) auf im Wesentlichen äquivalenten Drücken gehalten werden.

30. Vorrichtung nach Anspruch 18, wobei die Dockstation (27) auf einem Druck gehalten wird, der im Wesentlichen dem der ersten und zweiten Kammer (11, 15) gleicht.

## Revendications

1. Procédé de traitement d'articles comprenant :
la prévision d'une première chambre (11) configurée pour traiter au moins un article ;
la prévision d'une deuxième chambre (15) pour mettre en place l'au moins un article ;
la prévision d'un système de transport (43) linéaire ;
la prévision d'un premier robinet-vanne (13) positionné entre et en communication avec les première et deuxième chambres (11, 15), ledit premier robinet-vanne (13) ayant une position fermée pour isoler la première chambre (11) et une position ouverte pour permettre un passage entre la première chambre (11) et la deuxième chambre (15) ;
la prévision d'une station d'accueil (27) configurée pour charger et décharger l'au moins un article ;
la prévision d'un deuxième robinet-vanne (25) positionné entre et en communication avec la deuxième chambre (15) et la station d'accueil (27), ledit deuxième robinet-vanne (25) ayant une position fermée pour isoler la deuxième chambre (15) et une position ouverte pour permettre un passage entre la deuxième chambre (15) et la station d'accueil (27) ;
la prévision d'au moins une pompe à vide (19) en communication avec la première ou la deuxième chambre (11, 15) ;
la prévision d'une pluralité de plateaux porteurs (29, 31) configurés pour supporter l'au moins un article à traiter ;
le chargement de l'au moins un article sur un de la pluralité de plateaux porteurs (29, 31) ;
l'établissement et le maintien d'une basse pression dans les première et deuxième chambres (11, 15) tout en transportant au moins un de la pluralité de plateaux porteurs (29, 31) par l'intermédiaire du système de transport (43) linéaire entre les première et deuxième chambres (11, 15) de telle façon qu'un plateau porteur (29, 31) comprenant l'au moins un article à traiter est disposé dans la première chambre (11) ; et
le traitement de l'au moins un article supporté par le plateau porteur (29, 31) dans la première chambre (11) ;
**caractérisé en ce que** le système de transport (43) linéaire comprend une pluralité d'ensembles de rails (45, 47), un nombre des ensembles de rails (45, 47) correspondant à un nombre des plateaux porteurs (29, 31), configurés pour se déplacer latéralement indépendamment les uns des autres le long du système de transport (43) linéaire entre la première chambre (11) et la deuxième chambre (15), dans lequel chacun de la pluralité d'ensembles de rails (45, 47) est configuré pour supporter un de la pluralité de plateaux porteurs (29, 31).

2. Procédé selon la revendication 1, dans lequel la station d'accueil (27) comprend un chargeur et déchargeur (33) d'article.

3. Procédé selon la revendication 1, dans lequel le système de transport (43) linéaire comprend un système d'entraînement choisi parmi le groupe consistant en :
des systèmes hydrauliques, des systèmes électromécaniques et des systèmes d'entraînement à couplage magnétique.

4. Procédé selon la revendication 1, dans lequel le système de transport (43) linéaire comprend un système d'entraînement à couplage magnétique.

5. Procédé selon la revendication 1, comprenant en outre les étapes de :
positionnement du premier robinet-vanne (13) dans la position fermée et activation de la pompe à vide (19) pour réduire la pression dans la première chambre (11) ;
ouverture du deuxième robinet-vanne (25) et envoi d'un de la pluralité de plateaux porteurs (29, 31) chargé avec au moins un article de la station d'accueil (27) jusque dans la deuxième chambre (15) ;
fermeture du deuxième robinet-vanne (25) et réduction de la pression dans la deuxième chambre (15) à une pression sensiblement similaire à la pression dans la première chambre (11) ; et
ouverture du premier robinet-vanne (13) et envoi du plateau porteur (29, 31) de la deuxième chambre (15) jusque dans la première chambre (11) par l'intermédiaire du système de transport (43) linéaire et traitement de l'au moins un article.

6. Procédé selon la revendication 5, dans lequel un différentiel de pression prédéterminé existe entre les première et deuxième chambres (11, 15) avant que le premier robinet-vanne (13) ne soit ouvert.

7. Procédé selon la revendication 6, dans lequel le différentiel de pression prédéterminé est inférieur à environ 10 à 1 Torr.

8. Procédé selon la revendication 5, comprenant en outre les étapes de :
engagement du système de transport (32) linéaire pour transporter le plateau porteur entre des chambres de pressions sensiblement similaires le long de l'ensemble de rails (45, 47).

9. Procédé selon la revendication 1, dans lequel le chargement de l'au moins un article sur les plateaux porteurs (29, 31) est accompli par un robot (33).

10. Procédé selon la revendication 9, comprenant en outre les étapes de :
prévision d'une pluralité d'articles provenant d'une source d'articles destinés à être chargés sur un de la pluralité de plateaux porteurs (29, 31) ; et
engagement du robot (33) pour charger les articles sur un de la pluralité de plateaux porteurs (29, 31).

11. Procédé selon la revendication 1, comprenant en outre les étapes de :
après traitement de l'article, mise du deuxième robinet-vanne (25) dans la position fermée et du premier robinet-vanne (13) dans la position ouverte ;
envoi d'un de la pluralité de plateaux porteurs (29, 31) de la première chambre (11) jusqu'à la deuxième chambre (15) ;
mise du premier robinet-vanne (13) dans la position fermée ; et
ouverture du deuxième robinet-vanne (25) et envoi d'un robot (33) pour enlever l'article traité de l'un de l'au moins un plateau porteur (29, 31).

12. Procédé selon la revendication 11, dans lequel le système de transport (43) linéaire comprend un mécanisme d'entraînement à couplage magnétique.

13. Procédé selon la revendication 1, comprenant en outre les étapes de :
prévision d'au moins un article à traiter, ledit article prévu sur une station d'accueil (27) ;
transfert de l'article jusqu'à la deuxième chambre (15) à partir de la station d'accueil (27) à travers un deuxième robinet-vanne (25) ;
équilibrage substantiel des première et deuxième chambres (11, 15) à une pression sensiblement similaire ;
transport de l'article de la deuxième chambre (15) à travers le premier robinet-vanne (13) jusqu'à la première chambre (11) le long du système de transport (43) linéaire ; et
transport de l'article de la première chambre (11) à travers le premier robinet-vanne (13) jusqu'à la deuxième chambre (15) le long du système de transport (43) linéaire.

14. Procédé selon la revendication 13, comprenant en outre l'étape de : mise des premier et deuxième robinets-vannes (13, 25) dans les positions ouverte ou fermée pour faciliter le transport de l'article jusque dans et hors de la première chambre (11) tout en soumettant l'article à une pression sensiblement constante.

15. Procédé selon la revendication 13, comprenant en outre les étapes de :
mise du premier robinet-vanne (13) dans une position fermée lors du traitement de l'article dans la première chambre (11) tout en introduisant simultanément au moins un article à traiter dans la deuxième chambre (15) ;
après l'introduction d'au moins un article dans la deuxième chambre (15), mise du deuxième robinet-vanne (25) dans une position fermée, et mise du premier robinet-vanne (13) dans une position ouverte ;
transport d'au moins un article de la première chambre (11) à travers le premier robinet-vanne (13) jusqu'à la deuxième chambre (15) le long du système de transport (43) linéaire ; et
transport d'au moins un article de la deuxième chambre (15) à travers le premier robinet-vanne (13) jusqu'à la première chambre (11) le long du système de transport (43) linéaire.

16. Procédé selon la revendication 13, dans lequel le système de transport (43) linéaire comprend un mécanisme d'entraînement à couplage magnétique.

17. Procédé selon la revendication 13, comprenant en outre l'étape de : maintien de la station d'accueil (27) à une pression sensiblement similaire aux première et deuxième chambres (11, 15).

18. Appareil pour traiter un article dans un environnement basse pression comprenant :
une première chambre (11) configurée pour traiter un article ;
une pluralité de plateaux porteurs (29, 31) configurés pour supporter au moins un article à traiter ;
une deuxième chambre (15) configurée pour mettre en place l'au moins un article à traiter à envoyer dans la première chambre (11) ou à envoyer hors de la première chambre (11) ;
un système de transport (43) linéaire ;
un premier robinet-vanne (13) positionné entre et en communication avec les première et deuxième chambres (11, 15), ledit premier robinet-vanne (13) ayant une position fermée pour isoler la première chambre (11) et une position ouverte pour permettre un passage entre la première chambre (11) et la deuxième chambre (15) ;
une station d'accueil (27) configurée pour charger et décharger l'au moins un article ;
un deuxième robinet-vanne (25) positionné entre et en communication avec la deuxième chambre (15) et la station d'accueil (27), ledit deuxième robinet-vanne (25) ayant une position fermée pour isoler la deuxième chambre (15) et une position ouverte pour permettre un passage entre la deuxième chambre (15) et la station d'accueil (27) ; et
au moins une pompe à vide (19) en communication avec la première ou la deuxième chambre (11, 15) ;
**caractérisé en ce que** le système de transport (43) linéaire comprend une pluralité d'ensembles de rails (45, 47), un nombre des ensembles de rails (45, 47) correspondant à un nombre des plateaux porteurs (29, 31), configurés pour se déplacer latéralement indépendamment les uns des autres le long du système de transport (43) linéaire entre la première chambre (11) et la deuxième chambre (15), dans lequel chacun de la pluralité d'ensembles de rails (45, 47) est configuré pour supporter un de la pluralité de plateaux porteurs (29, 31).

19. Appareil selon la revendication 18, dans lequel une basse pression est établie et maintenue dans les première et deuxième chambres (11, 15) tout en transportant au moins un de la pluralité de plateaux porteurs (29, 31) entre les première et deuxième chambres (11, 15), et tout en traitant l'article maintenu dans le plateau porteur dans la première chambre (11).

20. Appareil selon la revendication 18, dans lequel chacun de la pluralité de plateaux porteurs (29, 31) est configuré pour supporter une pluralité d'articles.

21. Appareil selon la revendication 20, dans lequel les articles comprennent une pluralité de tranches.

22. Appareil selon la revendication 18, dans lequel la pluralité de plateaux porteurs (29, 31) sont en forme de dôme.

23. Appareil selon la revendication 18, dans lequel le système de transport (43) linéaire comprend un mécanisme d'entraînement choisi parmi le groupe consistant en : un mécanisme d'entraînement à couplage magnétique, un mécanisme d'entraînement hydraulique, un mécanisme d'entraînement pneumatique, un mécanisme d'entraînement électromécanique et un mécanisme d'entraînement mécanique.

24. Appareil selon la revendication 18, dans lequel le système de transport (43) linéaire comprend au moins un mécanisme d'entraînement à couplage magnétique.

25. Appareil selon la revendication 18, comprenant en outre un moyen automatisé (33) pour envoyer des tranches jusqu'à la pluralité de plateaux porteurs (29, 31) avant le traitement des tranches.

26. Appareil selon la revendication 18, comprenant en outre un moyen automatisé (33) pour enlever des tranches traitées de la pluralité de plateaux porteurs (29, 31).

27. Appareil selon la revendication 25, dans lequel le moyen automatisé comprend un robot (33).

28. Appareil selon la revendication 26, dans lequel le moyen automatisé comprend un robot (33).

29. Appareil selon la revendication 18, dans lequel les première et deuxième chambres (11, 15) sont maintenues à des pressions sensiblement équivalentes.

30. Appareil selon la revendication 18, dans lequel la station d'accueil (27) est maintenue à une pression sensiblement similaire aux première et deuxième chambres (11, 15).
